(19) Europäisches Patentamt
European Patent Office
Office européen des brevets

(11) **EP 2 028 686 B1**

(12) **EUROPÄISCHE PATENTSCHRIFT**

(45) Veröffentlichungstag und Bekanntmachung des Hinweises auf die Patenterteilung:
**08.08.2012  Patentblatt 2012/32**

(51) Int Cl.:
***H01L 21/768*** *(2006.01)*

(21) Anmeldenummer: **08167849.2**

(22) Anmeldetag: **20.11.2003**

(54) **Verfahren zum galvanischen Aufbringen eines Metalls, insbesondere von Kupfer, und Verwendung dieses Verfahrens**

Method for electrodepositing a metal, especially copper, and use of said method

Méthode de déposition d'un métal, specialement du cuivre, par électrolyse, et l'utilisation de cette méthode

(84) Benannte Vertragsstaaten:
**DE**

(30) Priorität: **23.11.2002  DE 10254815**

(43) Veröffentlichungstag der Anmeldung:
**25.02.2009   Patentblatt 2009/09**

(62) Dokumentnummer(n) der früheren Anmeldung(en) nach Art. 76 EPÜ:
**03767441.3 / 1 563 534**

(73) Patentinhaber: **Infineon Technologies AG**
**85579 Neubiberg (DE)**

(72) Erfinder:
• **Bradl, Stephan**
  **93051 Regensburg (DE)**
• **Kerkel, Klaus**
  **93073 Neutraubling (DE)**
• **Lindner, Christine**
  **90602 Pyrbaum (DE)**

(74) Vertreter: **Karl, Frank**
**Kindermann Patentanwälte**
**Postfach 100234**
**85593 Baldham (DE)**

(56) Entgegenhaltungen:
US-A- 5 824 599      US-A- 6 153 521
US-B1- 6 249 055     US-B1- 6 313 529

• **D. Widmann, H. Mader, H. Friedrich: "Technologie hochintegrierter Schaltungen", 1996, Springer Verlag ISBN: 3-540-59357-8 page 249,**

**Beschreibung**

Die Erfindung betrifft ein Verfahren zum Aufbringen von Metall oder einer Metalllegierung bei der Herstellung einer integrierten Schaltungsanordnung. Bei dem Verfahren werden in einer Isolierschicht einer integrierten Schaltungsanordnung eine Vielzahl von Kontaktlöchern zu Leitbahnen einer Metallisierungsschicht erzeugt. Anschließend wird eine Barriereschicht aufgebracht, beispielsweise aufgesputtert.

Das Kontaktloch wird auch als Via bezeichnet, wenn es nicht unmittelbar bis zu einem Halbleiterträgersubstrat der integrierten Schaltungsanordnung führt. Das Kontaktloch hat bspw. einen Durchmesser, der wesentlich kleiner als 1 $\mu$m ist (Mikrometer) oder der größer als 1 $\mu$m oder sogar größer als 10 $\mu$m ist.

Die Barriereschicht dient bspw. zur Verbesserung der Haftung zwischen dem Metall und der Isolierschicht. Außerdem dient die Barriereschicht bspw. als Diffusionssperre für die Atome des Metalls. Es soll verhindert werden, dass Atome auf Grund ihres großen Diffusionskoeffizienten bis in aktive Bereiche des Halbleiterträgersubstrats vordringen und dort die elektrischen Eigenschaften von integrierten Halbleiterbauelementen ungewollt verändern.

Aus der US 6,153,521 sind eine metallisierte Zwischenverbindungsstruktur und ein Verfahren zu deren Herstellung bekannt, bei dem eine Keimbildungsschicht und ein Resist verwendet werden. Die Keimbildungsschicht ist typischerweise eine Stapelschicht eines Refraktärmetalls oder eines Refraktärmetallnitrids und einer Kupferabscheidungs-Keimbildungsschicht, die vorzugsweise eine Kupferlegierung oder reines Kupfer enthält.

Aus der US 6,249,055 B1 ist eine sich selbst einkapselnde Kupfermetallisierung bekannt. In einem galvanischen Verfahren wird auf einer Aluminiumlegierung ganzflächig Kupfer abgeschieden, d.h. ohne Verwenden eines Resists. Die Strukturierung erfolgt dann durch chemisch mechanisches Polieren.

Aus der US 5,824,599 ist die geschützte Einkapselung der katalytischen Schicht für eine stromlose Kupferzwischenverbindung bekannt. Bei einer ganzflächigen außenstromlosen Kupferabscheidung zersetzt sich eine Aluminiumschutzschicht auf einer Kupferkeimbildungsschicht.

Aus der US 6,313,529 B1 ist eine Halbleiteranordnung bekannt, die mit Lötmittel gebondet und versiegelt wird.

Es ist Aufgabe der Erfindung, ein einfaches Verfahren zum Aufbringen eines Metalls anzugeben, insbesondere von Kupfer oder einer Kupferlegierung. Außerdem sollen Verwendungen des Verfahrens angegeben werden.

Die auf das Verfahren bezogene Aufgabe wird durch die im Patentanspruch 1 angegebenen Verfahrensschritte gelöst. Weiterbildungen sind in den Unteransprüchen angegeben.

Die Erfindung geht von der Überlegung aus, dass steigende Anforderungen an die Leistungsfähigkeit von Halbleiterchips zu immer größeren Packungsdichten bei gleichzeitig immer höheren Stromdichten in den Metallisierungsebenen bzw. Metallisierungslagen der integrierten Schaltungsanordnung führen, insbesondere bei sogenannten Leistungshalbleitern, mit denen mehrere Ampere zu schalten sind. Probleme durch Elektromigration und durch Erwärmung treten in den Vordergrund und limitieren die Leistungsfähigkeit der Bauelemente. Einen Ausweg stellt z.B. die Verwendung von Kupfer oder von Kupferlegierungen an Stelle von Wolfram bzw. Aluminium dar. Kupfer ermöglicht im Vergleich zu den genannten Werkstoffen höhere Stromdichten und eine um den Faktor 2 bessere Wärmeleitfähigkeit. Aufgrund seines hohen Diffusionskoeffizienten im Silizium stellt Kupfer jedoch auch gleichzeitig ein erhebliches Risiko für alle Transistorebenen dar. Durch eine Diffusion von Kupferatomen in die aktiven Bereiche verändert sich beispielsweise die Einsatzspannung, die Kanallänge bzw. die Schaltzeit eines Transistors.

Mit anderen Worten ausgedrückt, wirken die diffundierten Atome bspw. als:

- Störstelle,
- Zentrum für Ladungsträger Generation oder Rekombination,
- Ursache für die Verkürzung der Lebensdauer von Ladungsträgern, und/oder
- Keime für oxidationsinduzierte Stapelfehler und Schwachstellen in dünnen Oxidschichten.

Selbst ein Ausfall eines Transistors ist möglich. Demzufolge muss die Diffusion von Kupferatomen bzw. anderen Atome mit großem Diffusionskoeffizienten in Silizium unterbunden werden. Dazu ist die Barriereschicht allein nicht ausreichend, weil auch eine Kupfer-Querkontamination innerhalb der Produktionslinie verhindert werden muss.

Die Erfindung geht deshalb weiterhin von der Überlegung aus, dass in einer Halbleiterfertigung, in der bspw. Kupfer, in den Metallisierungsebenen verwendet wird, streng zwischen der sogenannten FEOL-Fertigung (Front End of Line) und der sogenannten BEOL-Fertigung (Back End of Line) getrennt werden muss. Dabei betrifft die FEOL-Fertigung u.a. Verfahrensschritte zum Herstellen von STI (Shallow Trench Isolation), von LOCOS-Isolationen (LOCal Oxidization of Silicon), die Herstellung von Transistoren, einschließlich der erforderlichen Implantationen. Die BEOL-Fertigung betrifft u.a. die Herstellung von Metallisierungs- und Passivierungsebenen. Wird beispielsweise nur die letzte Metallisierungslage unter Verwendung eines Metalls, dessen Atome in Silizium einen großen Diffusionskoeffizienten haben, hergestellt, so wird die BEOL-Fertigung nochmals in zwei Teilbereiche unterteilt. Die Unterteilung führt zu einer anlagentechnischen Dedizierung. Das bedeutet, dass eine kontaminierte Anlage nicht für Prozesse verwendet werden darf, bei denen eine Querkontamination zwischen verschiedenen Anlagen kritisch ist. Häufig muss diese Anlage sogar räumlich von anderen Produktionsbereichen getrennt werden.

Das erfindungsgemäße Verfahren nutzt eine galvanische Abscheidung des Metalls mit Außenstrom, die sich sowohl zum Abscheiden kleinerer Schichtdicken zwischen 30 nm und 300 nm, aber auch zum Abscheiden größerer Schichtdicken eignet. So lassen sich Schichtdicken größer als 1 $\mu$m oder größer als 10 $\mu$m mit einem Verfahren mit Außenstrom erzeugen.

Es wird bei dem erfindungsgemäßen Verfahren eine Grenzelektrodenschicht verwendet, deren Atome in Silizium einen kleinen Diffusionskoeffizienten haben, d.h. gerade keinen großen Diffusionskoeffizienten. Dies bietet bspw. den Vorteil, dass ein lithografisches Verfahren zum Festlegen der Lage der galvanisch zu erzeugenden Metallstrukturen ggf. bis auf das Resistentfernen vollständig mit Maschinen durchführbar ist, die bei der Durchführung des Verfahrens nicht mit dem Metall kontaminiert werden, aus dem die galvanisch abgeschiedene Metallschicht besteht. Diese Anlagen stehen daher der Produktion uneingeschränkt zur Verfügung.

Zusätzlich zur Barriereschicht wird eine Grenzelektrodenschicht aufgebracht.

Damit beim Aufbringen der Grenzelektrodenschicht und beim Aufbringen weiterer Schichten, bspw. einer strahlungsempfindlichen Schicht, keine Kontaminationen auftreten, besteht die Grenz-elektrodenschicht aus Aluminium oder einer Aluminiumlegierung, dessen Atome in Silizium einen kleinen Diffusionskoeffizienten haben, d.h. gerade keinen großen Diffusionskoeffizienten D.

Bei der Erfindung werden auch folgende Schritte ausgeführt:

- Aufbringen einer strahlungsempfindlichen Schicht nach dem Aufbringen der Barriereschicht und der Grenzelektrodenschicht,
- Bestrahlen der strahlungsempfindlichen Schicht gemäß einem Muster,
- Entwickeln der strahlungsempfindlichen Schicht nach dem Bestrahlen,
- Aufbringen eines Metalls oder einer Metalllegierung in Bereiche, die nach dem Entwickeln frei von der strahlungsempfindlichen Schicht sind, mit Hilfe eines galvanischen Verfahrens,
- nach dem Aufbringen des Metalls oder der Metalllegierung Entfernen von Resten der strahlungsempfindlichen Schicht.

Bei der Erfindung hat das galvanisch aufzubringende Metall bzw. die galvanisch aufzubringende Metalllegierung einen großen Diffusionskoeffizienten in Silizium. Der Diffusionskoeffizient der Atome des Metalls ist bei 400°C größer als $10^{-9}$ cm$^2$/s. So gilt für Kupfer für eine Temperatur T im Bereich zwischen 400°C (Grad Celsius) und 900°C:

$$D[cm^2/s] = 4,7 \ 10^{-3} \ \exp(-e_a/kT),$$

wobei $e_a$ die Aktivierungsenergie in eV (Elektronenvolt) ist, hier 0,43 eV, und k die Boltzmannkonstante ist.

Gleiches gilt für eine galvanisch aufzubringende Metalllegierung, in der mehr als 5 Gewichts-%, mehr als 50 Gewichts-% oder sogar mehr als 90 Gewichts-% der Atome in Silizium einen großen Diffusionskoeffizienten haben.

Erfindungsgemäß wird das galvanische Verfahren unter Verwendung einer äußeren Strom- oder Spannungsquelle durchgeführt. Die äußere Strom- oder Spannungsquelle führt unter anderem zu einer höheren Abscheidegeschwindigkeit. Außerdem werden dem galvanischen Bad bei einem Verfahren mit Außenstrom bspw. Reduktionsmittel und Katalysatoren zugesetzt.

Aluminium als Material der Grenzelektrodenschicht hat in der elektrochemischen Spannungsreihe ein kleineres Potential als das galvanisch abgeschiedene Metall oder die galvanisch abgeschiedene Metalllegierung. Die elektrochemische Spannungsreihe gibt die sich einstellenden Spannungen verschiedener Materialien an, wenn diese mit einer Bezugselektrode, nämlich einer Wasserstoffelektrode, zu einer galvanischen Zelle kombiniert werden. Beispielsweise gilt:

| | |
|---|---|
| Li | - 3,04 V (Volt), |
| Al | - 1, 66 V, |
| Ti | - 1,628 V, |
| Ni | - 0,23 V, |
| $H_2$ | 0 V, |
| Cu | + 0,35 V, |
| Ag | + 0,8 V, |
| Hg | + 0,85 V, |
| Pt | + 1,2 V, |

(fortgesetzt)

Au        + 1,41 V.

Beispielsweise gilt für Kupfer Cu, dass mit wenigen Ausnahmen, z.B. für Gold Au, für Platin Pt, für Quecksilber Hg und für Silber Ag, nahezu alle Metalle im Beisein von Kupferionen oxidiert werden, wobei unedlere Metalle in Lösung gehen und sich die in Lösung befindlichen Kupferionen als metallischer Überzug niederschlagen.

Bei einer Weiterbildung des erfindungsgemäßen Verfahrens wird nach dem Entfernen der strahlungsempfindlichen Schicht ein Ätzvorgang durchgeführt, bei dem die Barriereschicht gemäß den beim Galvanisieren entstandenen Metallstrukturen geätzt wird, vorzugsweise in einem einfachen nass-chemischen Ätzprozess.

Bei einer anderen Weiterbildung enthält die Leitbahn Aluminium oder eine Aluminiumlegierung, beispielsweise Aluminium mit einem geringen Zusatz von Silizium oder Kupfer, z.B. von einem Gewichtsprozent. Die erfindungsgemäßen Verfahren eignen sich besonders für die Herstellung der obersten Metallisierungslage. Beispielsweise bestehen die unteren Metallisierungslagen aus Aluminium oder einer Aluminiumlegierung, die z.B. mehr als 90 Gewichts-% oder mehr als 95 Gewichts-% Aluminium enthält, d.h. aus einem gut prozessierbaren Material.

Die Barriereschicht enthält bei einer nächsten Weiterbildung beispielsweise Wolfram, Titan oder Tantal, d.h. Metalle mit einem Schmelzpunkt größer als 1600°C. Bei einer Ausgestaltung wird auch eine Nitridschicht eines solchen Metalls eingesetzt. Diese Barriereschichten sind als Diffusionssperre und Haftvermittlungsschichten besonders geeignet.

Die zusätzlich auf die Barriereschicht aufgebrachte Grenzelektrodenschicht besteht aus Aluminium oder einer Aluminiumlegierung, die z.B. mehr als 90 Gewichts-% oder mehr als 95 Gewichts-% Aluminium enthält, d.h. aus einem prozesstechnisch gut zu bearbeitenden Material.

Bei einer nächsten Weiterbildung ist das galvanisch abgeschiedene Metall Kupfer, Gold, Silber oder Platin. Es werden auch Metalllegierungen mit mehreren dieser Stoffe eingesetzt.

Bei einer anderen Weiterbildung hat das Kontaktloch einen Durchmesser größer als 1 $\mu$m (Mikrometer) größer als 10 $\mu$m oder sogar größer als 20 $\mu$m. Die Schichtdicke der abgeschiedenen Schicht ist bei einer Ausgestaltung größer als 100 nm (Nanometer) oder größer als 500 nm oder sogar größer als 10 $\mu$m beim Verfahren mit Außenstrom zum Galvanisieren.

Die Erfindung betrifft außerdem eine Verwendung eines erfindungsgemäßen Verfahrens zum Herstellen eines integrierten Leistungs-Schaltkreises, durch den beim Schalten Ströme größer als 1 A (Ampere), größer als 10 A oder sogar größer als 100 A fließen.

Bei einer anderen Verwendung der erfindungsgemäßen Verfahren dienen die Verfahren zur Herstellung einer Vielzahl von Trägerschaltkreisen und zur Herstellung einer Vielzahl von getragenen Schaltkreisen. Eine Vielzahl ist beispielsweise eine Produktionsmenge von mehreren 1000 Schaltkreisen. Ein getragener Schaltkreis wird auf einem Trägerschaltkreis mit Hilfe einer Plättchen-Schnellmontagetechnik aufgebracht. Diese Technik wird auch als Flip-Chip-Technik bezeichnet. Beispielsweise werden die beiden Schaltkreise verlötet, so dass ihre aktiven Seiten einander zugewandt sind. Alternativ lassen sich auch andere Befestigungsverfahren der Flip-Chip-Technik verwenden.

Im Folgenden werden Ausgestaltungen der Erfindung an Hand der beiliegenden Zeichnungen erläutert. Darin zeigen:

Figuren 1A bis 1C    Herstellungsstufen bei der Herstellung einer Kupfermetallisierung gemäß einer ersten Verfahrensvariante mit einer Aluminium-Grenzelektroden schicht,

Figuren 2A bis 2C    Herstellungsstufen bei der Herstellung einer Kupfermetallisierung gemäß einer nicht erfindungsgemäßen zweiten Verfahrensvariante mit einer Barriereschicht als Keimbildungsschicht, und

Figur 3               eine in Flip-Chip-Technik hergestellte integrierte Schaltungsanordnung.

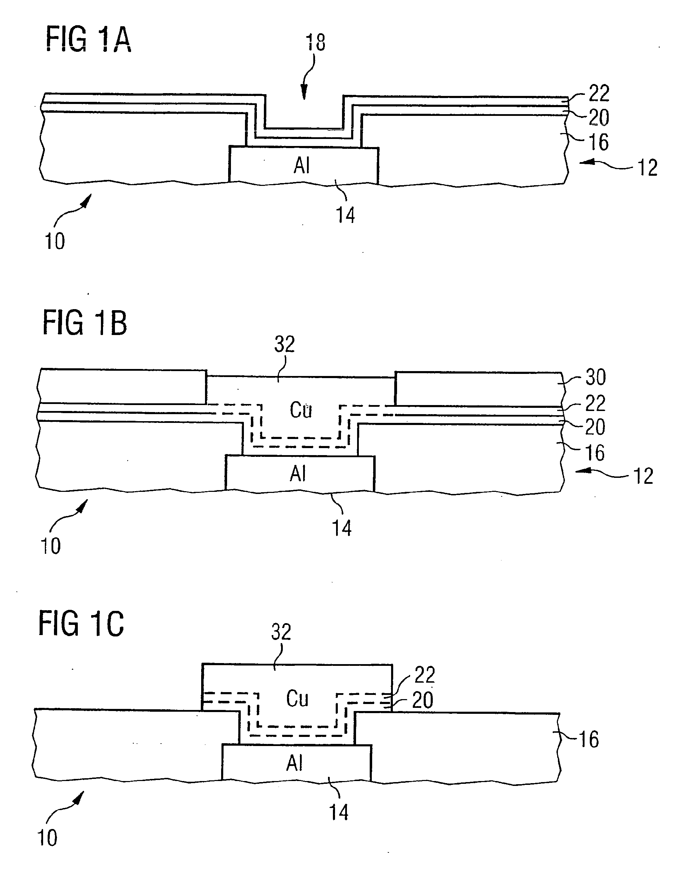

Figuren 1A bis 1C zeigen Herstellungsstufen der letzten Metallisierungslage einer integrierten Schaltungsanordnung 10 gemäß der Erfindung. Die integrierte Schaltungsanordnung 10 enthält bereits mindestens eine Metallisierungslage 12, in der eine Vielzahl von Aluminiumleitbahnen angeordnet sind, beispielsweise eine Leitbahn 14. Nach dem Herstellen der Metallisierungslage 12 wurde eine Isolierschicht 16 abgeschieden, beispielsweise aus Siliziumdioxid oder aus einem BPSG-Material (Borphosphorsilikatglas).

Mit Hilfe eines fotolithografischen Verfahrens wurden danach eine Vielzahl von Kontaktlöchern, d.h. von sogenannten Vias, in der Isolierschicht 16 erzeugt, beispielsweise ein Kontaktloch 18, das zu der Leitbahn 14 führt.

Anschließend wurde eine Barriereschicht 20 abgeschieden, die beispielsweise aus Wolframtitan WTi oder aus Nickel Ni besteht. Die Barriereschicht 20 wurde beispielsweise mit Hilfe eines Sputterverfahrens aufgebracht und hat eine Dicke unter 100 nm (Nanometer).

Danach wurde eine Aluminium Grenzelektrodenschicht 22 aufgebracht, beispielsweise mit Hilfe eines Sputterverfahrens. Die Aluminium- Grenzelektroden schicht 22 besteht aus Aluminium Al und hat im Ausführungsbeispiel eine Dicke von beispielsweise 50 nm. Bei anderen Ausführungsbeispielen ist die Dicke der Grenzelektroden schicht 22 ebenfalls kleiner als 100 nm.

Wie in Figur 1B dargestellt, wird anschließend eine Fotolackschicht 30 aufgebracht, die beispielsweise eine Dicke von 30 μm (Mikrometer) oder eine größere Dicke hat. Die Fotolackschicht 30 wird gemäß vorgegebener Maskenstrukturen belichtet und entwickelt, wobei sich Anlagen nutzen lassen, die nicht mit Kupfer kontaminiert sind und auch nicht mit Kupfer kontaminiert werden.

In einem nicht erfindungsgemäßen Verfahren wird nach dem Strukturieren der Fotolackschicht 30 ein außenstromloses Galvanisierungsverfahren unter Verwendung einer Kupfersulfatlösung CuSO$_4$ durchgeführt. Dabei scheidet sich ein Kupferkontakt 32 im Kontaktloch 18 und oberhalb des Kontaktlochs 18 ab. Während des Galvanisierens wird die Aluminium schicht 22 im Bereich des Kontaktlochs 18 zersetzt. Die Barriereschicht 20 wird nur in einer oberen Teilschicht zersetzt, so dass sie ihre Funktion als Diffusionssperre noch in ausreichendem Maße erfüllt.

Beim Beenden des außenstromlosen Verfahrens ragt der Kupferkontakt 32 nicht oder nur etwas in den unteren Teil der in der Fotolackschicht 30 enthaltenen Aussparung. Ist das Kontaktloch 18 am Ende des außenstromlosen Verfahrens bereits gefüllt, wird das Galvanisieren beendet. Ist das Kontaktloch 18 dagegen am Ende des außenstromlosen Verfahrens noch nicht gefüllt, oder soll der Kupferkontakt weiter über die Isolierschicht 16 hinausragen, so wird ein Verfahren mit Außenstrom zum weiteren Galvanisieren verwendet. Erfindunggemäß nur mit einem Außenstromverfahren galvanisiert.

Wie in Figur 1C dargestellt, werden anschließend die Reste der Fotolackschicht 30 entfernt. Danach wird mit einem nass-chemischen Ätzverfahren oder mit einem Trockenätzverfahren die Aluminium- um-Grenzelektroden schicht 22 in Bereichen entfernt, die nicht vom Kupferkontakt 32 bedeckt sind. Ebenfalls mit einem nass-chemischen Ätzverfahren oder mit einem Trockenätzverfahren wird die Barriereschicht 20 in Bereichen entfernt, die nicht von den Kupferkontakten, z.B. vom Kupferkontakt 32, bedeckt sind.

Das an Hand der Figuren 1A bis 1C erläuterte Verfahren lässt sich mit einer vergleichsweise dünnen Barriereschicht 20 durchführen. Dies erleichtert die Prozessführung. Beispielsweise haftet eine dünne Barriereschicht besser als eine dickere Barriereschicht.

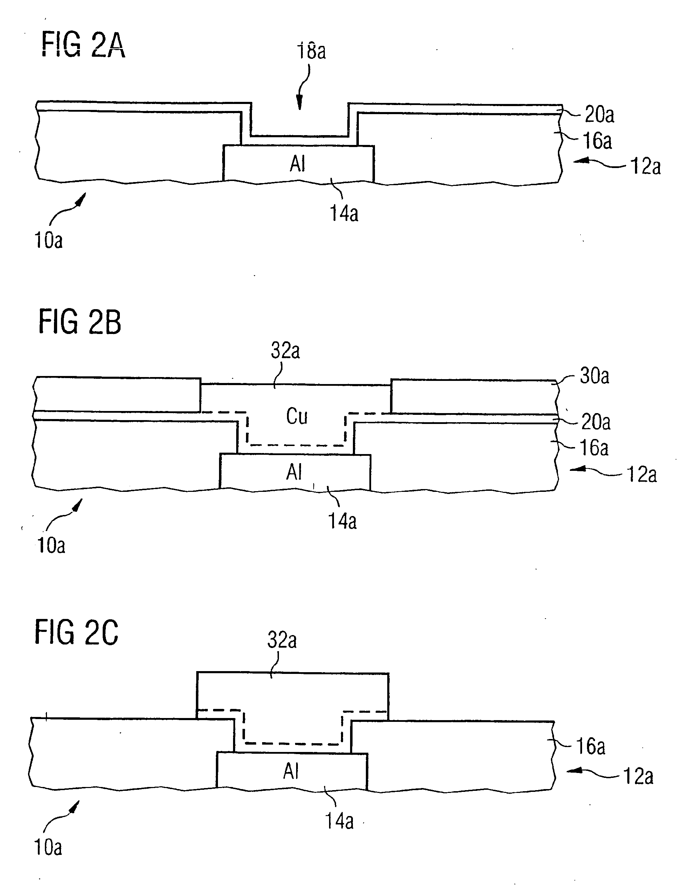

Die Figuren 2A bis 2C zeigen Herstellungsstufen bei der nicht erfindungsgemäßen Herstellung einer Kupfermetallisierung direkt auf einer Barriereschicht. Wie in Figur 2A dargestellt, enthält eine integrierte Schaltungsanordnung 10a eine Metallisierungslage 12a. Die Metallisierungslage 12a enthält eine Leitbahn 14a aus Aluminium. Auf die Metallisierungslage 12a wurde eine Isolierschicht 16a aufgebracht, die aus dem gleichen Material, wie die Isolierschicht 16 besteht. Danach wurde die Isolierschicht 16a mit Hilfe eines fotolithografischen Verfahrens strukturiert, wobei ein Kontaktloch 18a oberhalb der Leitbahn 14a erzeugt worden ist.

Anschließend wurde eine Barriereschicht 20a aufgebracht, die beispielsweise aus einer Doppelschicht Titan Ti und Titannitrid TiN besteht. Die Dicke der Barriereschicht 20a wurde so gewählt, dass Zugspannungen nicht zu stark werden und dass andererseits aber auch eine ausreichend dicke Schicht vorhanden ist nach einer teilweisen Zersetzung der Barriereschicht 20a in einem außenstromlosen galvanischen Verfahren.

Wie in Figur 2B dargestellt, wurde anschließend eine Fotolackschicht 30a auf die Barriereschicht 20a aufgebracht. Die Fotolackschicht 30a hat beispielsweise wieder eine Dicke von 30 μm. Die Fotolackschicht 30a wurde dann in einem fotolithografischen Verfahren belichtet und entwickelt, wobei wiederum Anlagen eingesetzt werden, die nicht mit Kupfer kontaminiert sind und auch nicht mit Kupfer kontaminiert werden. Anschließend wird bspw. mit Hilfe eines außenstromlosen Galvanisierungsverfahrens ein Kupferkontakt 32a aus Kupfer Cu im Bereich des Kontaktlochs 18a erzeugt. Während des Galvanisierens zersetzt sich eine obere Teilschicht der Barriereschicht 20a, siehe gestrichelte Linie 50.

Wie in Figur 2C dargestellt, werden anschließend die Reste der Fotolackschicht 30a entfernt, beispielsweise durch einen nasschemischen Reinigungsschritt. In einem nass-chemischen Ätzprozess wird danach die Barriereschicht 20a in Bereichen entfernt, die nicht vom Kupferkontakt 32a bedeckt sind.

Alternativ wird bei dem an Hand der Figuren 2A bis 2C erläuterten Verfahren nur ein galvanisches Verfahren mit Außenstrom oder ein kombiniertes Verfahren eingesetzt.

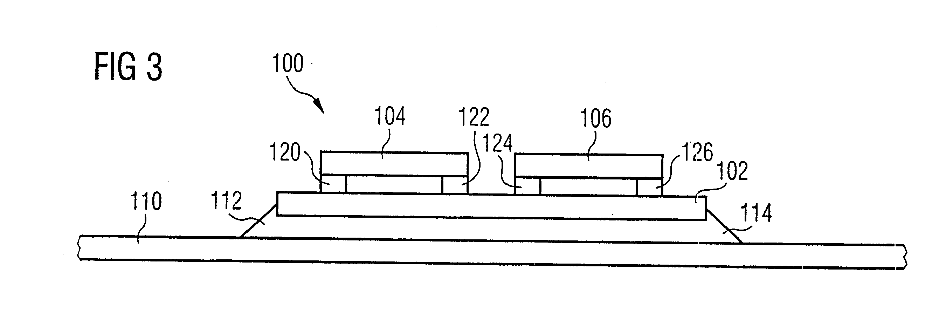

Figur 3 zeigt eine Anordnung 100 aus einem integrierten Prozessorschaltkreis 102 und aus zwei integrierten Speicherschaltkreisen 104 und 106. Die Anordnung 100 ist auf einer Leiterplatte 110 angeordnet, wobei Anschlussdrähte 112 und 114 vom Prozessorschaltkreis 102 zur Leiterplatte 110 führen.

Die integrierten Schaltungsanordnungen 102 bis 106 sind mit dem an Hand der Figuren 1A bis 1C bzw. mit dem an Hand der Figuren 2A bis 2C erläuterten Verfahren hergestellt worden. Nach der Herstellung der integrierten Schaltkreise 102 bis 106 wurden die beiden Speicherschaltkreise 104 und 106 in einer sogenannten Plättchen-Schnellmontage-Technik (Flip-Chip Technik) mit dem Prozessorschaltkreis 102 verlötet, siehe Lötstellen 120 bis 126. Alternativ lässt sich eine Klebetechnik einsetzen. Die aktiven Seiten der Speicherschaltkreise 104 und 106 sind der aktiven Seite des Prozessorschaltkreises 102 zugewandt.

Die in Figur 3 dargestellte Anordnung lässt sich nur dann rentabel in großer Zahl herstellen, wenn zur Herstellung der integrierten Schaltkreise 102 bis 106 das erfindungsgemäße Verfahren eingesetzt wird. Bei anderen Verfahren wäre die Kontamination von Anlagen nicht mehr vertretbar.

Die oben erläuterte Prozessführung hat folgende Vorteile:

- Aluminiumbearbeitungsverfahren sind Standardprozesse im BEOL,
- es lassen sich vorhandene Anlagen und Prozesse uneingeschränkt nutzen,
- eine Dedizierung von Belichtungsanlagen ist nicht notwendig,
- geringe Kosten,
- eine klare Trennung von FEOL zu BEOL,
- keine Kontaminationsgefahr, und
- höhere Flexibilität und Modularität.

**Patentansprüche**

1. Verfahren zum Aufbringen von Metall (32), bei dem die folgenden Verfahrensschritte ausgeführt werden:

   Erzeugen eines Kontaktlochs (18) zu einer Leitbahn (14) in einer Isolierschicht (16) einer integrierten Schaltungsanordnung (10),
   ganzflächiges Aufbringen einer Barriereschicht (20) nach dem Erzeugen des Kontaktlochs (18),
   ganzflächiges Aufbringen einer Grenzelektroden Schicht (22) aus Alu- minium oder aus einer Aluminiumlegierung auf der Barriereschicht (20) , Aufbringen einer strahlungsempfindlichen Resist-Schicht (30) nach dem Aufbringen der Barriereschicht (20) und der Grenzelektroden Schicht (22) aus Aluminium oder aus einer Aluminiumlegie-rung,
   Bestrahlen der strahlungsempfindlichen Resist-Schicht (30) gemäß einem Muster,
   Entwickeln der strahlungsempfindlichen Resist-Schicht (30) nach dem Bestrahlen, wobei die Grenzelektroden Schicht (22) aus Alumini-um oder aus einer Aluminiumlegierung im Bereich des Kontakt-lochs (18) freigelegt wird,
   Aufbringen eines Metalls (32) oder einer Metalllegierung im freigelegten Geheit mit Hilfe eines galvanischen Verfahrens unter Verwendung einer äußeren Strom- oder Spannungsquelle,
   wobei beim Aufbringen der Resist-Schicht, Bestrahlen und Entwickeln Anlagen genutzt werden, die nicht mit Metall identisch zu dem mit Hilfe des galvanischen Verfahrens aufgebrachten Metall kontaminiert sind und bei dem Verfahren auch nicht mit derartigen Metall kontaminiert werden,
   nach dem Aufbringen des Metalls (32) Entfernen der nach dem Entwickeln verbliebenen Teile der strahlungsempfindlichen Resist-Schicht (30),
   und wobei die Atome des Metalls in Silizium bei 400°C einen Diffusionskoeffizienten größer als $10^{-9}$ cm$^2$/s haben oder wobei in der Metalllegierung mehr als 5 % der Atome in Silizium bei 400°C einen Diffusionskoeffizienten größer als $10^{-9}$ cm$^2$/s haben.

2. Verfahren nach einem der vorhergehenden Ansprüche, **dadurch gekennzeichnet, dass** nach dem Entfernen der strahlungsempfindlichen Resist-Schicht ein Ätzvorgang durchgeführt wird, bei dem die Grenzelektroden Schicht (22) aus Aluminium oder aus einer Aluminiumlegierung und die Barriereschicht (20) gemäß der entstandenen Metallstrukturen geätzt werden, vorzugsweise in einem nass-chemischen Ätzprozess und/oder ohne Durchführung eines weiteren lithografischen Verfahrens.

3. Verfahren nach einem der vorhergehenden Ansprüche, da - **durch gekennzeichnet**, dass die Leitbahn (14) aus Aluminium oder aus einer Aluminiumlegierung besteht.

4. Verfahren nach einem der vorhergehenden Ansprüche, **dadurch gekennzeichnet , dass** die Barriereschicht (20) ein Metall mit einem Schmelzpunkt größer als 1600 °C enthält,
   und/oder dass die Barriereschicht (20) ein Metall ent-hält, dessen Atome in Silizium einen Kleinen Diffusionskoeffizienten haben,
   und/oder dass die Barriereschicht (20) ein Nitrid enthält, vorzugsweise ein Metallnitrid, oder dass die Barriereschicht aus einem Nitrid besteht, vorzugsweise aus einem Metallnitrid,
   und/oder dass die Barriereschicht (20) einen oder mehrere der Stoffe Wolfram, Nickel, Tantal, Tantalnitrid, Titan oder Titannitrid enthält.

5. Verfahren nach einem der vorhergehenden Ansprüche, **dadurch gekennzeichnet, dass** das Metall Kupfer, Gold, Silber oder Platin ist,
oder dass die Metalllegierung mindestens einen dieser Stoffe zu mehr als 40 Gewichtsprozent enthält.

6. Verfahren nach einem der vorhergehenden Ansprüche, **dadurch gekennzeichnet, dass** das Kontaktloch (18) einen Durchmesser größer als 1 $\mu$m oder größer als 10 $\mu$m oder größer als 20 $\mu$m hat, und/oder dass die Schichtdicke der galvanischen Schicht größer als 100 nm, größer als 500 nm oder größer als 1 $\mu$m ist.

7. Verfahren nach einem der vorhergehenden Ansprüche, **dadurch gekennzeichnet, dass** das Metall Kupfer ist und dass beim Bestrahlen und Entwickeln Anlagen genutzt werden, die nicht mit Kupfer kontaminiert sind und bei dem Verfahren auch nicht mit Kupfer kontaminiert werden.

8. Verwendung des Verfahrens nach einem der vorhergehenden Ansprüche zum Herstellen einer integrierten Leistungs-Schaltungsanordnung, die Ströme größer als 1 A, größer als 10 A oder größer als 100 A schaltet, und/oder Verwendung des Verfahrens zum Herstellen einer Vielzahl von Trägerschaltkreisen (102) und getragenen Schaltkreisen (104, 106), wobei jeweils mindestens ein getragener Schaltkreis (104, 106) auf einem Trägerschaltkreis (102) angeordnet wird und wobei Seiten mit aktiven Bauelementen einander zugeordnet sind, insbesondere unter Verwendung einer Plättchen-Schnellmontage-Technik, vorzugsweise durch Verlöten des getragenen Schaltkreises (104, 106) und des Trägerschaltkreises (102).

**Claims**

1. Method for the application of metal (32),
   in which the following method steps are performed:

   production of a contact hole (18) to an interconnect (14) in an insulating layer (16) of an integrated circuit arrangement (10),
   application of a barrier layer (20) over the whole area after the production of the contact hole (18),
   application of a boundary electrode layer (22) composed of aluminium or composed of an aluminium alloy over the whole area on the barrier layer (20),
   application of a radiation-sensitive resist layer (30) after the application of the barrier layer (20) and of the boundary electrode layer (22) composed of aluminium or composed of an aluminium alloy,
   irradiation of the radiation-sensitive resist layer (30) in accordance with a pattern,
   development of the radiation-sensitive resist layer (30) after the irradiation, wherein the boundary electrode layer (22) composed of aluminium or composed of an aluminium alloy is uncovered in the region of the contact hole (18),
   application of a metal (32) or a metal alloy in the uncovered region with the aid of a galvanic method using an external current or voltage source,
   wherein, during the application of the resist layer, irradiation and development, installations are used which are not contaminated with metal identical to the metal applied with the aid of the galvanic method and are also not contaminated with metal of this type during the method,
   after the application of the metal (32), removal of the parts of the radiation-sensitive resist layer (30) that remained after the development,
   and wherein the atoms of the metal have a diffusion coefficient of greater than $10^{-9}$ cm$^2$/s at 400°C in silicon or wherein in the metal alloy more than 5% of the atoms have a diffusion coefficient of greater than $10^{-9}$ cm$^2$/s at 400°C in silicon.

2. Method according to one of the preceding claims, **characterized in that**, after the removal of the radiation-sensitive resist layer, an etching operation is carried out in which the boundary electrode layer (22) composed of aluminium or composed of an aluminium alloy and the barrier layer (20) are etched in accordance with the metal structures produced,
   preferably in a wet-chemical etching process and/or without carrying out a further lithographic method.

3. Method according to one of the preceding claims, **characterized in that** the interconnect (14) comprises aluminium or an aluminium alloy.

4. Method according to one of the preceding claims, **characterized in that** the barrier layer (20) contains a metal having a melting point of greater than 1600°C,
and/or **in that** the barrier layer (20) contains a metal whose atoms have a small diffusion coefficient in silicon,
and/or **in that** the barrier layer (20) contains a nitride, preferably a metal nitride, or **in that** the barrier layer comprises a nitride, preferably a metal nitride,
and/or **in that** the barrier layer (20) contains one or more of the substances tungsten, nickel, tantalum, tantalum nitride, titanium or titanium nitride.

5. Method according to one of the preceding claims, **characterized in that** the metal is copper, gold, silver or platinum, or **in that** the metal alloy contains more than 40% by weight of at least one of said substances.

6. Method according to one of the preceding claims, **characterized in that** the contact hole (18) has a diameter of greater than 1 $\mu$m or greater than 10 $\mu$m or greater than 20 $\mu$m,
and/or **in that** the layer thickness of the galvanic layer is greater than 100 nm, greater than 500 nm or greater than 1 $\mu$m.

7. Method according to one of the preceding claims, **characterized in that** the metal is copper, and **in that**, during irradiation and development, installations are used which are not contaminated with copper and are also not contimanted with copper during the method.

8. Use of the method according to one of the preceding claims for fabricating an integrated power circuit arrangement which switches currents of greater than 1A, greater than 10A or greater than 100A,
and/or the use of the method for fabricating a multiplicity of carrier circuits (102) and carried circuits (104, 106), in each case at least one carried circuit (104, 106) being arranged on a carrier circuit (102), and sides with active components being assigned to one another, in particular using a chip rapid-mounting technique, preferably by soldering the carried circuit (104, 106) and the carrier circuit (102).

**Revendications**

1. Procédé de dépôt de métal (32),
dans lequel on effectue les stades de procédé suivants :

on produit un trou (18) de contact vers une piste (14) conductrice dans une couche (16) isolante d'un agencement (10) de circuit intégré,
on dépose sur toute la surface une couche (20) formant barrière, après la production du trou (18) de contact,
on dépose sur toute la surface une couche (22) limite d'électrode en aluminium ou en un alliage d'aluminium sur la couche (20) formant barrière,
on dépose une couche (30) de réserve sensible au rayonnement, après le dépôt de la couche (20) formant barrière et de la couche (22) limite d'électrode en aluminium ou en un alliage d'aluminium, on expose la couche (30) de réserve sensible au rayonnement suivant un motif,
on développe la couche (30) de réserve sensible au rayonnement après l'exposition, la couche (22) limite d'électrode en aluminium ou en un alliage d'aluminium étant mise à nu dans la zone du trou (18) de contact,
on dépose un métal (32) ou un alliage de métal dans la zone mise à nu à l'aide d'un procédé galvanique en utilisant une source extérieure de courant ou de tension,
dans lequel, lors du dépôt de la couche de réserve, de l'exposition et du développement, on utilise des installations qui ne sont pas contaminées par du métal identique au métal déposé à l'aide du procédé galvanique et qui ne sont pas non plus contaminées, dans le procédé, par du métal de ce genre, après le dépôt du métal (32), on élimine les parties restant après le développement de la couche (30) de réserve sensible au rayonnement,
et dans lequel les atomes du métal ont dans le silicium à 400°C un coefficient de diffusion plus grand que $10^{-9}$ $cm^2$/s ou
dans lequel, dans l'alliage de métal, plus de 5 % des atomes ont dans le silicium à 400°C un coefficient de diffusion plus grand que $10^{-9}$ $cm^2$/s.

2. Procédé suivant l'une des revendications précédentes, **caractérisé en ce que**, après l'élimination de la couche de réserve sensible au rayonnement, on effectue une opération d'attaque, dans laquelle on attaque la couche (22) limite d'électrode en aluminium ou en un alliage d'aluminium et la couche (20) formant barrière suivant les structures métalliques créées, de préférence dans une opération d'attaque chimique en voie humide et/ou sans effectuer un autre procédé lithographique.

3. Procédé suivant l'une des revendications précédentes, **caractérisé en ce que** la piste (14) conductrice est en aluminium ou en un alliage d'aluminium.

4. Procédé suivant l'une des revendications précédentes, **caractérisé en ce que** la couche (20) formant barrière contient un métal ayant un point de fusion plus haut que 1 600°C,
et/ou **en ce que** la couche (20) formant barrière contient un métal dont les atomes ont dans du silicium un coefficient de diffusion petit,
et/ou **en ce que** la couche (20) formant barrière contient un nitrure, de préférence un nitrure métallique, ou **en ce que** la couche formant barrière est constituée d'un nitrure, de préférence d'un nitrure métallique,
et/ou **en ce que** la couche (20) formant barrière contient une ou plusieurs des substances tungstène, nickel, tantale, nitrure de tantale, titane ou nitrure de titane.

5. Procédé suivant l'une des revendications précédentes, **caractérisé en ce que** le métal est du cuivre, de l'or, de l'argent ou du platine,
ou **en ce que** l'alliage de métal contient au moins l'une de ces substances pour plus de 40 pourcent en poids.

6. Procédé suivant l'une des revendications précédentes, **caractérisé en ce que** le trou (18) de contact a un diamètre plus grand que 1 $\mu$m ou plus grand que 10 $\mu$m ou plus grand que 20 $\mu$m, et/ou **en ce que** l'épaisseur de la couche galvanique est plus grande que 100 nm, plus grande que 500 nm ou plus grande que 1 $\mu$m.

7. Procédé suivant l'une des revendications précédentes, **caractérisé en ce que** le métal est du cuivre et **en ce que**, lors de l'exposition et du développement, on utilise des installations qui ne sont pas contaminées par du cuivre et, dans le procédé, ne sont pas non plus contaminées par du cuivre.

8. Utilisation du procédé suivant l'une des revendications précédentes pour la production d'un agencement de circuit intégré de puissance, qui admet des courants supérieurs à 1 A, supérieurs à 10 A ou supérieurs à 100 A,
et/ou utilisation du procédé pour la production d'une pluralité de circuits (102) de support et de circuits (104, 106) portés, respectivement au moins un circuit (104, 106) porté étant disposé sur un circuit (102) support et des côtés ayant des composants actifs étant associés l'un à l'autre, notamment en utilisant une technique de montage rapide de plaquettes, de préférence par brasage du circuit (104, 106) porté et du circuit (102) porteur.

## FIG 1A

18

22
20
16
12

Al

10
14

## FIG 1B

32

30
Cu
22
20
16
12

Al

10
14

## FIG 1C

32

22
Cu
20

16

Al

10
14

## FIG 2A

18a

20a
16a
12a

Al

14a

10a

## FIG 2B

32a

30a

Cu

20a
16a
12a

Al

14a

10a

## FIG 2C

32a

16a
12a

Al

14a

10a

FIG 3

EP 2 028 686 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6153521 A
- US 6249055 B1
- US 5824599 A
- US 6313529 B1